# EUROPEAN PATENT APPLICATION

(11) **EP 2 813 926 A2**
(43) Date of publication of application: **17.12.2014**
(21) Application number: 14172273.6
(22) Date of filing: 13.06.2014
(51) Int. Cl.: G06F 3/041

(54) **Decoration cover plate**

(30) Priority: 14.06.2013 TW 102121192
(71) Applicant: Wintek Corporation, 42760 Taichung City (TW)
(72) Inventor: Chen, Hsuan-Yang, 973 Ji'an Township (TW); Huang, Yi-Hsuan, 420 Taichung City (TW); Lai, Tzung-Fu, 413 Taichung City (TW)
(74) Representative: Chew, Kwan Chong Daniel

(57) **Abstract**

A decoration cover plate is provided. The decoration cover plate includes a substrate having an appearance decoration layer, an auxiliary light-shielding layer and a buffer layer stacked thereon. The buffer layer is disposed between the appearance decoration layer and the auxiliary light-shielding layer. The auxiliary light-shielding layer and the appearance decoration layer are opposite to each other. An optical density of the auxiliary light-shielding layer is greater than an optical density of the appearance decoration layer.

## Description

### BACKGROUND OF THE INVENTION

### Field of the Invention

The invention generally relates to a decoration cover plate, and more particularly, to a decoration cover plate with high light-shielding property.

### Description of Related Art

In order to transmit signals, a touch panel having sensing elements is configured with a plurality of transmission lines connected to the sensing elements thereof; however, to reduce the transmission impedance, the touch panel usually uses visible metallic transmission lines and black light-shielding material to avoid the transmission lines being seen. In order to effectively maximize the display area of the touch panel, the transmission lines are usually disposed at the peripheral area of the touch panel. At this time, the touch panel can have a black decorative frame to hide the transmission lines. However, for users, the black decorative frame does not necessarily meet the needs of users on the appearance, so that the relevant manufactures put forward an idea of using non-black decorative frame to hide the transmission lines.

Since a non-black decorative layer made of non-black decorative material has poor light-shielding performance, other low-transmittance material (for example, black ink) is often used to form a low-transmittance layer contacted with the non-black decorative layer for assisting light-shielding purpose and for effectively shielding the visible element behind it. However, the overall appearance of the touch panel may become worse due to an interaction between the low-transmittance layer and the non-black decorative layer may result in a color change of the non-black decorative layer, for example, the non-black decorative layer may become impure or yellow. In detail, there may be a chemical reaction between the low-transmittance layer and the non-black decorative layer; or a non-black decorative material penetration phenomenon may occur due to the particle size of the non-black decorative material is smaller than the pores in the non-black decorative layer.

### SUMMARY OF THE INVENTION

Accordingly, the invention provides a decoration cover plate having a non-black decorative region with ideal light-shielding effect out of the transparent region thereof.

A decoration cover plate of the invention has a transparent region and a light-shielding region, in which the light-shielding region is located at at least one side of the transparent region. The decoration cover plate includes a substrate, an appearance decoration layer, an auxiliary light-shielding layer and a buffer layer. The substrate is made of transparent material. The appearance decoration layer is disposed on the substrate and within the light-shielding region. The auxiliary light-shielding layer is disposed within the light-shielding region, in which the auxiliary light-shielding layer and the appearance decoration layer are opposite to each other, and an OD of the auxiliary light-shielding layer is greater than an OD of the appearance decoration layer. The buffer layer is at least disposed between the appearance decoration layer and the auxiliary light-shielding layer, in which a material of the buffer layer is different from a material of the appearance decoration layer and a material of the auxiliary light-shielding layer.

Based on the description above, the appearance decoration layer and the auxiliary light-shielding layer are disposed within the light-shielding region, and the buffer layer is disposed between the appearance decoration layer and the auxiliary light-shielding layer. By disposing the buffer layer between the appearance decoration layer and the auxiliary light-shielding layer, the penetrating phenomenon of the auxiliary light-shielding layer can be prevented or mitigated to keep the original color of the appearance decoration layer, which further makes the presented color of the light-shielding region have ideal saturation. In addition, the appearance decoration layer allows the decoration cover plate to have a non-black decorative color, and the auxiliary light-shielding layer can compensate insufficient light-shielding property of the appearance decoration layer so as to provide ideal light-shielding effect.

Other objectives, features and advantages of the present invention will be further understood from the further technological features disclosed by the embodiments of the present invention wherein there are shown and described preferred embodiments of this invention, simply by way of illustration of modes best suited to carry out the invention.

### BRIEF DESCRIPTION OF THE DRAWINGS

The accompanying drawings are included to provide a further understanding of the disclosure, and are incorporated in and constitute a part of this specification. The drawings illustrate embodiments of the disclosure and, together with the description, serve to explain the principles of the invention.
Fig. 1A is a top-view diagram of a touch panel using a decoration cover plate according to an embodiment of the invention.
Fig. 1B is a cross-sectional diagram of Fig. 1A along line I-I.
Fig. 1C is a partial cross-sectional diagram of a touch panel using a decoration cover plate according to another embodiment of the invention.
Fig. 1D is a partial cross-sectional diagram of a touch panel using a decoration cover plate according to yet another embodiment of the invention.
Fig. 2 is a diagram showing the stacked layers in the light-shielding region of a touch panel using a decoration cover plate according to an embodiment of the invention.
Fig. 3 is a diagram showing the stacked layers in the light-shielding region of a touch panel using a decoration cover plate according to another embodiment of the invention.
Fig. 4 is a diagram showing the stacked layers in the light-shielding region of a touch panel using a decoration cover plate according to yet another embodiment of the invention.
Fig. 5A is a partial cross-sectional diagram of a touch panel using a decoration cover plate according to yet another embodiment of the invention.
Fig. 5B is a partial cross-sectional diagram of a touch panel using a decoration cover plate according to yet another embodiment of the invention.
Fig. 6 is a partial cross-sectional diagram in the light-shielding region of a touch panel using a decoration cover plate according to another embodiment of the invention.

### DESCRIPTION OF THE EMBODIMENTS

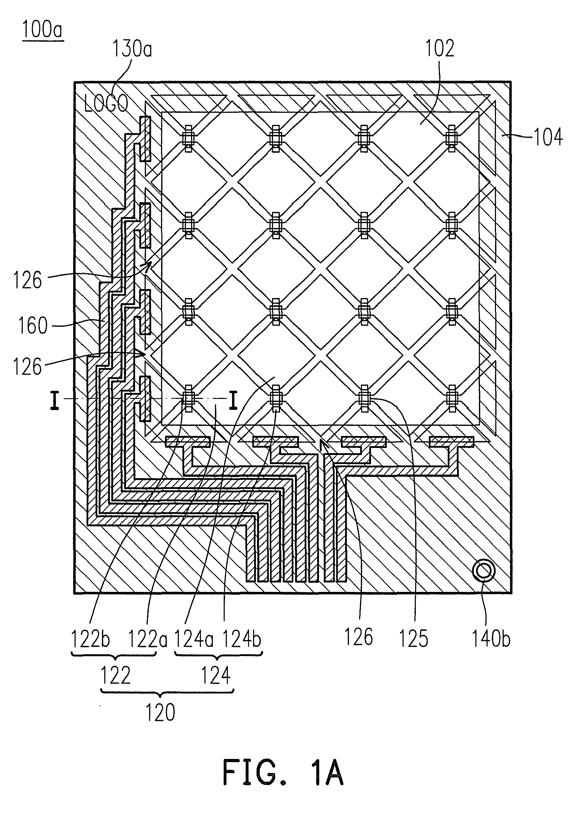

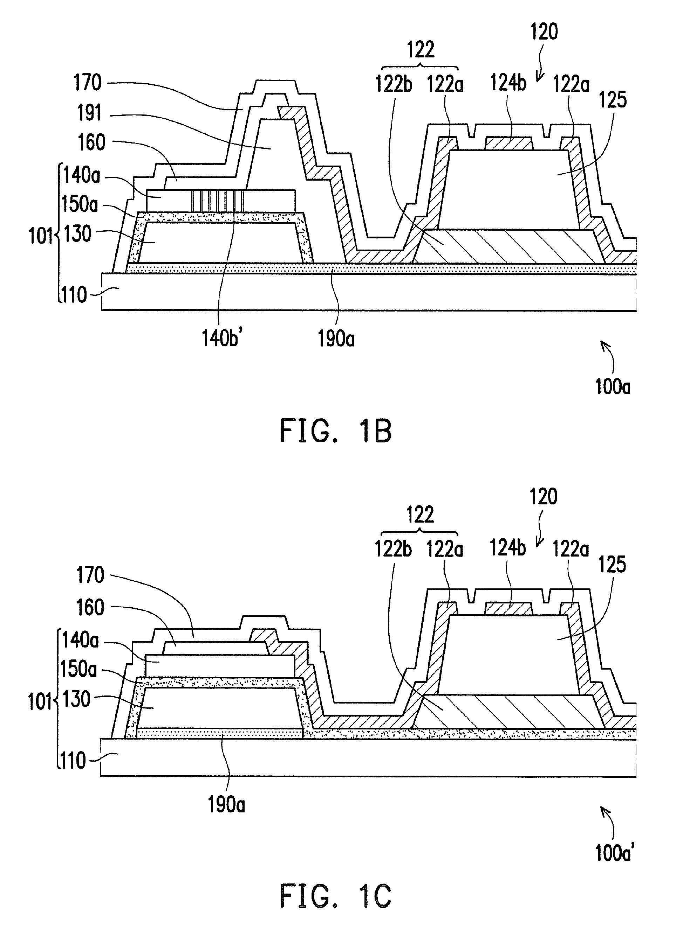

Fig. 1A is a top-view diagram of a touch panel using a decoration cover plate according to an embodiment of the invention and Fig. 1B is a cross-sectional diagram of Fig. 1A along line I-I. Referring to Figs. 1A and 1B, in the present embodiment, a touch panel 100a includes a decoration cover plate 101, a touch-sensing element 120, a plurality of transmission lines 160 and a protection layer 170. In the present embodiment, the touch-sensing element 120 and the transmission lines 160 made of conductive layers are supported by the decoration cover plate 101. The decoration cover plate 101 includes a substrate 110, an appearance decoration layer 130, an auxiliary light-shielding layer 140a and a buffer layer 150a. For an electronic device integrating a display function and a touch function, the touch panel 100a herein can further have a transparent region 102 and a light-shielding region 104 located at at least one side of the transparent region 102. The transparent region 102 is disposed correspondingly to a display element (for example, a liquid crystal display element or an organic light emitting diode display element) or other light sources, while the light-shielding region 104 is disposed correspondingly to the elements needed to be hidden, for example, the visible transmission lines 160. In order to maximize the display area of an electronic device, demands for a narrow border has growingly increased; thus, the visible transmission lines 160 are usually disposed at a peripheral area of the touch panel 100a, even more, the visible transmission lines 160 may be disposed at only one of sides of the touch panel 100a. Based on the same consideration, the light-shielding region 104 can be usually disposed at at least one side of the touch panel 100a where is corresponded to the area where the appearance decoration layer 130 or the auxiliary light-shielding layer 140a is disposed. Both the appearance decoration layer 130 and the auxiliary light-shielding layer 140a are made of a light resistant material which is defined as a material deemed to render a light lost when the light passes through an interface thereof, up to and including complete opacity, and is used to conceal elements or light not wanted to be seen.

In more details, the substrate 110 can be a rigid transparent substrate or a flexible transparent substrate made of, for example, glass or plastic, which the invention is not limited to. The substrate 110 can be made of an transparent insulation material selected from a chemically strengthened glass, a polarizer coated with a hard coat layer, a composite laminate composed of poly (methyl methacrylate) (PMMA) and polycarbonate (PC), an ultraviolet curable resin material (e.g., ORGA resin) or other rigid transparent insulation material having protection features like anti-scratch and high mechanical strength. The polarizer can be selected from a linear polarizer or a circular polarizer. Further, other additional optical layer like anti-glare layer or an antireflection layer can be disposed on a surface of the substrate 110 opposite to the surface where the auxiliary light-shielding layer 140a is disposed on. The thickness and the hardness of the additional optical layer less than the thickness and hardness of the substrate 110. The thickness the substrate 110 ranges between 0.2 mm and 2 mm. The appearance decoration layer 130 has the display color of the light-shielding region 104 of the touch panel 100a seen by the user. In the present embodiment, the light-shielding region 104 is corresponded to the peripheral area of the substrate 110; the auxiliary light-shielding layer 140a is disposed at a side of the appearance decoration layer 130 far away from the viewing side. The optical density (OD) of the auxiliary light-shielding layer 140a is greater than the OD of the appearance decoration layer 130 so as to provide an ideal light-shielding effect to hide the elements within the light-shielding region 104. In the present embodiment, the orthogonal projection of the auxiliary light-shielding layer 140a on the substrate 110 is overlapped with the orthogonal projection of the transmission line 160 on the substrate 110 to effectively hide the transmission lines 160 by the light-shielding region 104. For example, the auxiliary light-shielding layer 140a can have a color with lower brightness such as black, grey, blue, purple or silver color; while the appearance decoration layer 130 can have a color with higher brightness such as white, pink or Naples yellow color, which the invention is not limited to. In the embodiment, the OD of the auxiliary light-shielding layer 140a with thickness of 1 micrometer ranges between 3 and 4, while the OD of the appearance decoration layer 130 with thickness of 20 micrometers ranges between 0.8 and 0.9, which the invention is not limited to. For example, the appearance decoration layer 130 can be made of a material with an OD less than 3 or a material with an OD less than the OD of the transmission lines 160, while the auxiliary light-shielding layer 140a can be made of a material with an OD greater than the OD of the appearance decoration layer 130, and therefore, the OD of the auxiliary light-shielding layer 140a can be larger than 4.

In the embodiment, the light-shielding region 104 can have an image 130a which can be seen, for example, text, trademark, decorative pattern, or function key, etc. Referring to Figs. 1A and 1B again, a portion of the auxiliary light-shielding layer 140a can be patterned to form a light permeable pattern 140b. For example, the auxiliary light-shielding layer 140a can have a plurality of micro perforations 140b' arranged in a specific pattern to constitute the light permeable pattern 140b, and a luminous image appears when a backlight passes through the micro perforations 140b'.

The material of the appearance decoration layer 130 can include ceramic, organic material, mixture of organic and inorganic materials, or hybrid compound of organic and inorganic materials, and it can be a mono-layer structure or a stacked multi-layer structure using the same material in each layer. The thickness of the appearance decoration layer 130 can range between 0.5 micrometers and 50 micrometers, which the invention is not limited to. For example, the material of the appearance decoration layer 130 can be a photosensitive resin (e.g., photoresist) or a non-photosensitive resin (such as ink); the material of the auxiliary light-shielding layer 140a can include metal, metal compound, ceramic, diamond-like carbon, organic material, mixture of organic and inorganic materials or hybrid compound of organic and inorganic materials, which the invention is not limited to. For example, the material of the auxiliary light-shielding layer 140a can include chromium, aluminium, silver, copper, gold, titanium, tungsten, molybdenum, zinc, or compounds thereof; or the material of the auxiliary light-shielding layer 140a can be a photosensitive resin or a non-photosensitive resin (such as ink or other light-absorbing resin), in which the thickness of the auxiliary light-shielding layer 140a ranges between 0.3 micrometers and 20 micrometers.

The buffer layer 150a is at least disposed between the appearance decoration layer 130 and the auxiliary light-shielding layer 140a, in which the material of the buffer layer 150a is different from the materials of the appearance decoration layer 130 and the auxiliary light-shielding layer 140a. The buffer layer 150a is configured to avoid the auxiliary light-shielding layer 140a from affecting the hue of the appearance decoration layer 130 to further avoid appearance decoration layer 130 from undesirable phenomena of color-shift, yellowing or unexpected turbid color. The transmission lines 160 are disposed at a side of the auxiliary light-shielding layer 140a far away from the substrate 110 and electrically connected to the touch-sensing element 120. The protection layer 170 is disposed at a side of the visible transmission lines 160 far away from the substrate 110 and at least covers the touch-sensing element 120 and the transmission lines 160. In the present embodiment, the protection layer 170 is a continuous overlay full of the transparent region 102 covering the touch-sensing element 120 as well as the transmission lines 160 in the light-shielding region 104. The protection layer 170 is made of an insulation material, such as silicon dioxide, silicon nitride, other inorganic insulation material or other organic insulation materials. In some embodiments, the thickness of the protection layer 170 can be at least 0.8 micrometers so as to eliminate or reduce the height difference between the light-shielding region 104 and the transparent region 102. In other embodiments, the protection layer 170 can also provide an optical antireflection effect and be, for example, a bi-layer structure of silicon dioxide (SiO₂) and silicon nitride (SiNₓ) to effectively advance the overall transmittance of the touch panel 100a and reduce the visibility of the touch-sensing element 120.

Referring to Figs. 1A and 1B, in the embodiment, the touch-sensing element 120 disposed on the substrate 110 includes a plurality of first capacitive coupling unit 122 and a plurality of second capacitive coupling unit 124, in which the second capacitive coupling unit 124 intersects the first capacitive coupling unit 122, and the first capacitive coupling unit 122 and the second capacitive coupling unit 124 are insulated from each other. The terminal of each first capacitive coupling unit 122 is connected with a corresponding transmission line 160; the terminal of each second capacitive coupling unit 124 is connected with a corresponding transmission line 160. The touch-sensing element 120 is mainly disposed in the transparent region 102 and a part of the touch-sensing element 120 is disposed in the light-shielding region 104, that is, the touch-sensing element 120 is across the transparent region 102 and terminates at the light-shielding region 104. The touch-sensing element 120 can be made of invisible conductive material, including a transparent conductive material, such as indium tin oxide (ITO), indium-zinc oxide (IZO), gallium zinc oxide (GZO), carbon nanotube-based thin films, metal nanowires, such as silver nanowires, or other high conductive materials having an invisible linewidth, such as metal wire with a linewidth less than 10 µm, but not limited thereto. Accordingly, the active touch sensing region is wider than the transparent region 102, so that the touch sensitivity at the intersection of the transparent region 102 and the light-shielding region 104 can be equal to the touch sensitivity in the transparent region 102. Each of the first capacitive coupling unit 122 includes a plurality of first capacitive coupling pads 122a connected by a plurality of first connection lines 122b, while each of the second capacitive coupling unit 124 includes a plurality of second capacitive coupling pads 124a connected by a plurality of second connection lines 124b. The first capacitive coupling pads 122a and second capacitive coupling pads 124a are not overlapped and separated by insulation gaps 126 therebetween, and the first capacitive coupling unit 122 and the second capacitive coupling unit 124 are respectively separated by the insulation gaps 126 therebetween as well. A plurality of dielectric layers 125 are disposed between the first connection lines 122b and the second connection lines 124b, so that each first connection line 122b covered by the dielectric layers 125 is overlapped with and insulated from the corresponding second connection line 124b. Furthermore, at least one insulation pattern 191 may be disposed between the touch-sensing element 120 and the appearance decoration layer 130. In some embodiments, a plurality of discontinuous insulation patterns (not shown) can be optionally disposed on the appearance decoration layer 130 (not shown) corresponding to where the insulation gaps 126 are located and only partially overlapped with the touch-sensing element 120 on the appearance decoration layer 130 to ensure the dielectricity of the insulation gaps 126 and prevent the touch-sensing element 120 affected by the insulation patterns. Through the touch-sensing element 120, when a conductive object, such as finger, approaches to or contacts with an operating surface of the substrate 110 opposite to the surface where the touch-sensing element 120 disposed on, coupling capacitances between the object and the touch-sensing element 120 will establish, thereby cause a change in capacitance effects to detect the position of the object or the motion of the object by a self capacitance measurement method or a mutual capacitance measurement method. In addition, more examples of touch-sensing elements in various types are described following, but the invention does not limit touch-sensing element 120 thereto.

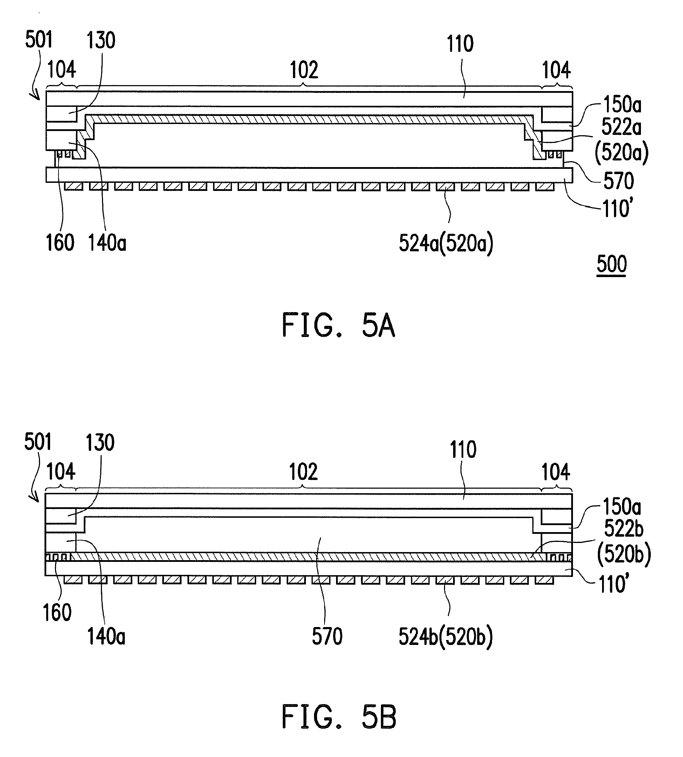

In some unshown embodiments, the touch-sensing element can be disposed on the substrate of the decoration cover plate. The touch-sensing element can include a plurality of first capacitive coupling unit, a plurality of second capacitive coupling unit and a plurality of transmission lines, and the above-mentioned elements are formed at the same surface on the substrate. The first capacitive coupling unit and the second capacitive coupling unit are separated and not overlapped. Each of the first capacitive coupling unit or the second capacitive coupling unit can include a plurality of capacitive coupling pads, each of the transmission lines is respectively electrically connected to the first capacitive coupling unit and the capacitive coupling pads of the second capacitive coupling unit, and the first capacitive coupling unit and the second capacitive coupling unit are insulated from each other. It should be noticed that the device referential numbers and a part of the contents of the aforementioned embodiment are adopted in the following embodiments, where the same reference numbers are used to refer to the same or like parts, and descriptions of the same technical contents are omitted. The aforementioned embodiment can be referred for descriptions of the omitted parts, which are not repeated in the following embodiments. A part of the transmission lines is disposed in the transparent region 102 terminates at the light-shielding region 104. In the transparent region 102, the transmission lines can be made of invisible conductive material, including a transparent conductive material, such as indium tin oxide (ITO), indium-zinc oxide (IZO), gallium zinc oxide (GZO), carbon nanotube-based thin films, metal nanowires, such as silver nanowires, or other high conductive materials having an invisible linewidth, such as metal wire with a linewidth less than 10 µm, but not limited thereto. In the light-shielding region 104, the transmission lines can include visible conductive material to reduce transmission impedance, or be connected with a visible circuit board. The first capacitive coupling unit and the second capacitive coupling unit can form capacitive couplings therebetween. In some embodiments, as shown in Fig. 5A, a touch-sensing element 520a of a touch panel 500 includes a plurality of first capacitive coupling unit 522a and a plurality of second capacitive coupling unit 524a, in which the first capacitive coupling unit 522a are disposed on the substrate 110 of the decoration cover plate 501, while the second capacitive coupling unit 524a are disposed on the other insulation base 110 '. The substrate 110 and the insulation base 110 ' are adhered to each other by using an adhesive layer 570. The buffer layer 150a is a continuous overlay not only disposed between the appearance decoration layer 130 and the auxiliary light-shielding layer 140a, but also disposed between the substrate 110 and the first capacitive coupling unit 522a. The first capacitive coupling unit 522a and the second capacitive coupling unit 524a are insulated from each other. The insulation base 110 ' may be a resin film or a glass substrate having a thickness less than the substrate 110.

In other embodiments, as shown in Fig. 5B, a touch-sensing element 520b of a touch panel 500 includes a plurality of first capacitive coupling unit 522b and a plurality of second capacitive coupling unit 524b, in which the first capacitive coupling unit 522b and the second capacitive coupling unit 524b can be respectively disposed at the two opposite sides of the insulation base 110', and the transmission lines 160 are disposed on the insulation base 110 ' as well and electrically connected to the touch-sensing element 520b. In the present embodiment, no touch-sensing element is formed on the decoration cover plate 501, but the decoration cover plate 501 is still required to protect the touch-sensing element 520b, hide the internal visible element and serve as the operating interface for the user. The decoration cover plate 501 is adhered to the insulation substrate 110 ' through the adhesive layer 570. In addition, the touch-sensing element in the invention can be other structure belong to the projected capacitive type and not limited thereto; for example, the touch-sensing element can include a plurality of conductive lines with a fixed width. Moreover, the capacitive coupling pads also do not limit the shape thereof, for example, they can be rhombus, triangle, or snowflake shapes.

The material of the buffer layer 150a can be insulation material including an organic material such as a photosensitive resin or a non-photosensitive resin, an inorganic insulation material, a mixture of organic and inorganic insulation materials or a hybrid compound of organic and inorganic insulation materials. The buffer layer 150a can be transparent or have a hue that visible light can pass through, and it can be a mono-layer structure or a stacked multi-layer structure using the same material in each layer, or formed by a plurality of stacked layers having at least two layers including different materials from each other. The preferred selected thickness of the buffer layer 150a including the organic material is between 0.01 micrometers and 10 micrometers, and the preferred selected refractive index thereof is between 1.2 and 2. The principal components of the buffer layer 150a made of inorganic insulation material can include nitride or oxide such as silicon oxide, titanium oxide, silicon nitride and titanium nitride, the preferred selected thickness thereof ranges between 0.001 micrometers and 10 micrometers and the preferred selected refractive index thereof is between 1.2 and 2. The material of the buffer layer 150a with a color can include resin and pigment, for example, the buffer layer 150a can be white ink and the preferred selected thickness thereof is between 0.5 micrometers and 100 micrometers.

As shown by Fig. 1C, when the buffer layer 150a is made of a transparent material, the buffer layer 150a can be a continuous overlay not only disposed within the light-shielding region 104 and between the appearance decoration layer 130 and the auxiliary light-shielding layer 140a, but also disposed within the transparent region 102, for example, between the touch-sensing element 120 and the substrate 110, between the first capacitive coupling unit 122 and the second capacitive coupling unit 124 (not shown), between the touch-sensing element 120 and the protection layer 170 (not shown) or to cover the touch-sensing element 120 (not shown). At the time, by employing the buffer layer 150a with a special range of refractive index, the buffer layer 150a can be matched with adjacent layers within the transparent region 102, such that the overall transmittance of the touch panel 100a' can be effectively advanced and the visibility of the touch-sensing element 120 is reduced. For example, the buffer layer 150a can be a bi-layer structure of silicon dioxide (SiO₂) and silicon nitride (SiNₓ), in which the refractive index of the silicon nitride is higher than the refractive index of the silicon dioxide, so that the reflection light from the buffer layer 150a and the reflection light from the touch-sensing element 120 interfere with one another to reduce the difference of refractive index between an area where touch-sensing element 120 is located and an area where corresponds to the insulation gaps 126. In some embodiments, in the light-shielding region 104, the touch-sensing element 120 can be disposed at a side of the auxiliary light-shielding layer 140a far away from the substrate 110 without contacting the appearance decoration layer 130 by disposing the buffer layer 150a therebetween. In the present embodiment, the buffer layer 150a is disposed on the surface of the appearance decoration layer 130 far away from the substrate 110, so that the touch-sensing element 120 can contact and be formed on the surfaces of the buffer layer 150a and the auxiliary light-shielding layer 140a to avoid the touch-sensing element 120 from contacting the appearance decoration layer 130. In this way, the invention is helpful to avoid the touch-sensing element 120 suffered the inaccurate patterning problem such as uncompleted etching or over-etching of conductive material on the appearance decoration layer 130 bumped relatively to the substrate 110.

In other embodiments, referring to Figs. 1B-1D, a second buffer layer 190a is employed and disposed between the appearance decoration layer 130 and the substrate 110 so as to provide additional functions such as increasing the stability of the appearance decoration layer 130 on the substrate 110 or/and adjusting the hue of the appearance decoration layer 130. The material of the second buffer layer 190a is different from the materials of the appearance decoration layer 130 and the substrate 110. In the present embodiment, the appearance decoration layer 130 is enclosed by the second buffer layer 190a and the buffer layer 150a. The material of the second buffer layer 190a in the embodiment can be insulation material including an organic material such as a photosensitive resin, or a non-photosensitive resin, an inorganic insulation material, a mixture of organic and inorganic materials or a hybrid compound of organic and inorganic materials. The preferred selected thickness of the second buffer layer 190a including the organic material is between 0.01 micrometers and 10 micrometers, and the preferred selected refractive index thereof is between 1.2 and 2. The principal components of the second buffer layer 190a made of inorganic insulation material can include nitride or oxide such as silicon oxide, titanium oxide, silicon nitride and titanium nitride, the preferred selected thickness thereof ranges between 0.001 micrometers and 10 micrometers and the preferred selected refractive index thereof is between 1.2 and 2. In some embodiments, the material of the second buffer layer 190a can be the same as the material of the buffer layer 150a.

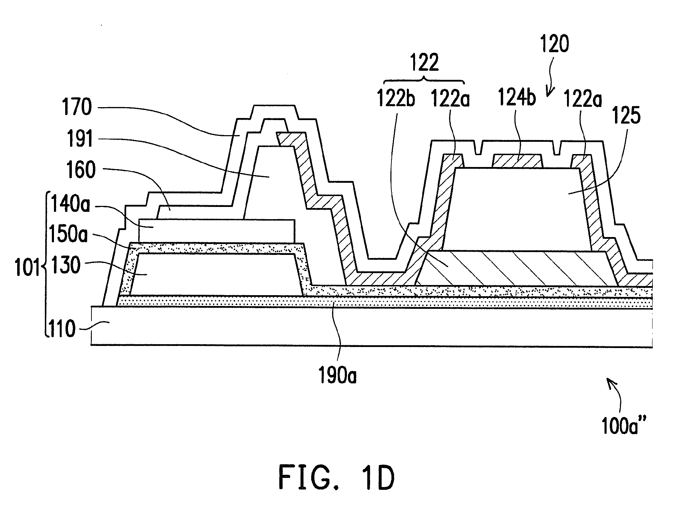

When the second buffer layer 190a is made of a transparent insulation material, the second buffer layer 190a can be a continuous overlay not only disposed within the light-shielding region 104 and between the appearance decoration layer 130 and the substrate 110, but also disposed within the transparent region 102 and between the touch-sensing element 120 and the substrate 110 as shown by Fig. 1B. In this way, the reliability of the touch panel or/and the overall transmittance is advanced. For example, the second buffer layer 190a can be a mono-layer structure of silicon dioxide (SiO₂) so that the touch-sensing element 120 can be deposited on an insulating interface with less impurity to advance the reliability of the touch panel. In other different applications, the second buffer layer 190a can be limited to be disposed between the appearance decoration layer 130 and the substrate 110, as shown by Fig. 1C. In Fig. 1D, both the second buffer layer 190a and the buffer layer 150a of the touch panel 100a" are continuous overlays not only disposed within the light-shielding region 104 but also disposed within the transparent region 102, in which both the second buffer layer 190a and the buffer layer 150a are disposed between the touch-sensing element 120 and the substrate 110. A refractive index of the second buffer layer 190a may be different from a refractive index of the buffer layer 150a and a refractive index of the substrate 110. Or, a refractive index of at least one of the buffer layer 150a and the substrate 110 may be the same as a refractive index of the second buffer layer 190a. For example, the second buffer layer 190a can be made of a high refractive index material, such as silicon nitride (SiNₓ), while the buffer layer 150a can be made of a low refractive index material, such as silicon dioxide (SiO₂).

As another option, in an alternative example of Fig. 1B, the second buffer layer 190a can be a bi-layer structure of silicon dioxide and silicon nitride, in which the refractive index of the silicon nitride is higher than the refractive index of the silicon dioxide, and the silicon nitride layer is closer to the substrate 110 than the silicon dioxide layer is to the substrate 110. At the time, by employing the second buffer layer 190a with a special range of refractive index, the second buffer layer 190a can be matched with the touch-sensing element 120 and the substrate 110 within the transparent region 102, such that the overall transmittance of the touch panel 100a can be effectively advanced and the visibility of the touch-sensing element 120 is reduced.

Any one of the appearance decoration layer 130, the auxiliary light-shielding layer 140a, the buffer layer 150a and the second buffer layer 190a containing resin may further include polymer, in which the polymer is, for example, siloxane, polyimide, polyurethane, polycarbonate, polyethylene, polystyrene, polyvinylchloride, acrylic or epoxy.

The transmission lines 160 can be made of conductive material such as metal, alloy, metallic stacked layers, alloy stacked layers or stacked layers of alloy and metal. The above-mentioned materials can be selected from, for example, chromium or compound thereof, aluminium or compound thereof, silver or compound thereof, copper or compound thereof, gold or compound thereof, or titanium or compound thereof, tungsten or compound thereof, molybdenum or compound thereof, zinc or compound thereof, or alloy composed of the above-mentioned metals. The material of the transmission lines 160 can be metallic stacked layers of molybdenum-aluminium-molybdenum.

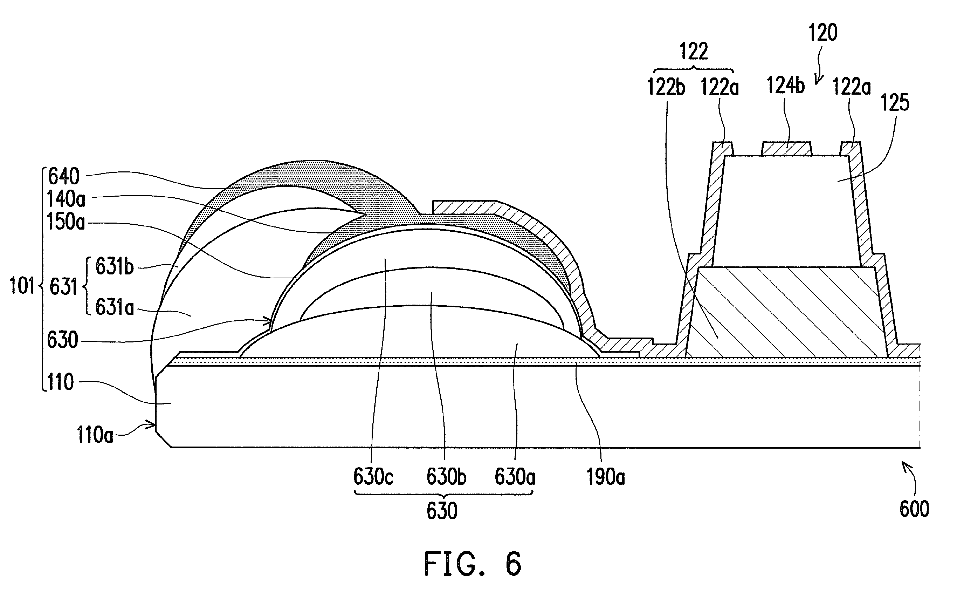

In some embodiments, as shown by Fig. 6, the decoration cover plate 101 applying to a touch panel 600 further includes a first border shielding layer 631 and a second border shielding layer 640 disposed on the substrate 110, in which the first border shielding layer 631 is disposed between the second border shielding layer 640 and the substrate 110. The outer edge of the appearance decoration layer 630 is separated from the edge of the substrate 110 by a distance. The appearance decoration layer 630 includes three stacked layers of white inks 630a, 630b and 630c. The first border shielding layer 631 includes two stacked layers of white inks 631a and 631b and at least covers a portion of an area where the appearance decoration layer 630 is located and covers the edge of the substrate 110. The second border shielding layer 640 at least covers a portion of an area where the first border shielding layer 631 is located. In the embodiment, the first border shielding layer 631 or the second border shielding layer 640 can extendedly cover the sidewalls 110a of the substrate 110, so as to effectively shield the light beam and avoid the light from leaking out of the sidewalls 110a of the substrate 110.

It should be noted that the component notations and partial details of the structures provided in the following embodiments can be the same as or similar to the previous embodiment, wherein the same notations represent the same or similar components while the repeated same details are omitted, which can refer to the previous embodiment.

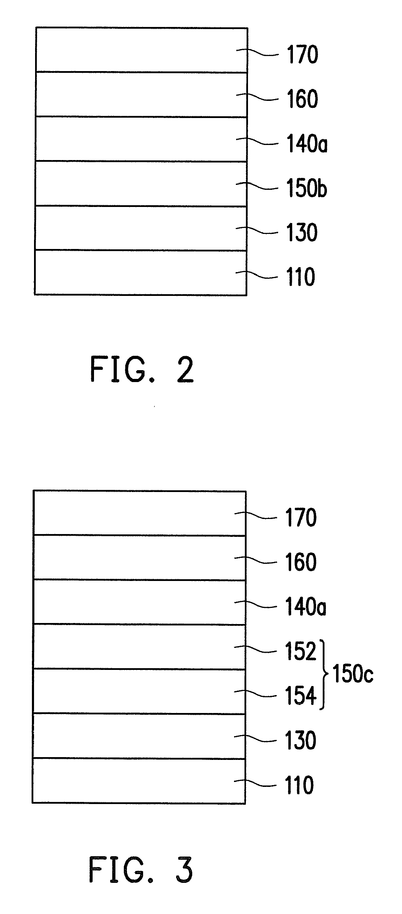

Fig. 2 is a diagram showing the stacked layers in the light-shielding region of a touch panel using a decoration cover plate according to an embodiment of the invention. In the embodiment, the buffer layer 150b is made of a light-permeable insulation material with a hue, which functions not only to buffer and block the influence of the auxiliary light-shielding layer 140a on the appearance decoration layer 130, but also to adjust and compensate the display color of the appearance decoration layer 130. For example, a white organic resin material disposed between the appearance decoration layer 130 made of white photoresist and the auxiliary light-shielding layer 140a made of black ink in the light-shielding region 104 can serve as the buffer layer 150b. In this way, the overall thickness of the white material layer is increased to advance the brightness thereof and the influence of the auxiliary light-shielding layer 140a on the display color of the appearance decoration layer 130 is effectively reduced.

Fig. 3 is a diagram showing the stacked layers in the light-shielding region of a touch panel using a decoration cover plate according to another embodiment of the invention. In the embodiment, the buffer layer 150c is stacked layers of a buffer layer 152 made of a transparent insulation material and a buffer layer 154 made of a light-permeable insulation material with a hue. The buffer layer 152 made of transparent insulation material herein is located between the auxiliary light-shielding layer 140a and the appearance decoration layer 130; the buffer layer 154 made of light-permeable insulation material with the hue is located between the buffer layer 152 and the appearance decoration layer 130. Accordingly, the influence of the auxiliary light-shielding layer 140a on the buffer layer 154 can be prevented, so that the buffer layer 154 can more stably adjust the display color of the appearance decoration layer 130 and avoid the auxiliary light-shielding layer 140a affecting the display color of the appearance decoration layer 130. However, the stacking sequence of the buffer layer 152 and the buffer layer 154 is not limited to the above-mentioned sequence. In some embodiments, the stacking sequence of the buffer layer 154 made of light-permeable insulation material with the hue and the buffer layer 152 made of transparent insulation material can be upside down.

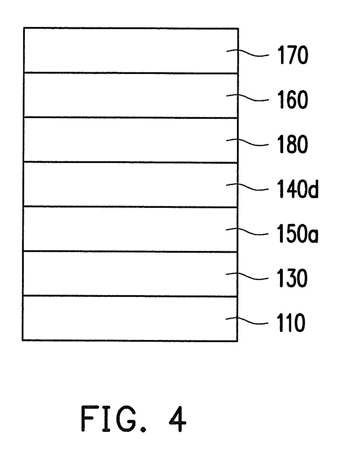

Fig. 4 is a diagram showing the stacked layers in the light-shielding region of a touch panel using a decoration cover plate according to yet another embodiment of the invention. In the embodiment, the auxiliary light-shielding layer 140d is metal or metallic compound, and the thickness of the auxiliary light-shielding layer 140d made of metal or metallic compound ranges, for example, between 0.05 micrometers and 0.5 micrometers. Since the auxiliary light-shielding layer 140d in the embodiment adopts metal or metallic compound, an insulation layer 180 is at least disposed at a surface of the auxiliary light-shielding layer 140d far away from the substrate 110 so as to be disposed between the auxiliary light-shielding layer 140d and the transmission lines 160 to avoid short circuit between the transmission lines 160 or other conductive materials need to be insulated each other disposed upon the auxiliary light-shielding layer 140d resulting from contacting the auxiliary light-shielding layer 140d.

In summary, the coverage of the appearance decoration layer and the auxiliary light-shielding layer of the invention can define the light-shielding region of the touch panel, in which the buffer layer is disposed between the appearance decoration layer and the auxiliary light-shielding layer. In this way, by using the buffer layer to avoid the influence of the auxiliary light-shielding layer on the appearance decoration layer, the display color of the light-shielding region can have ideal saturation. In addition, the appearance decoration layer allows the touch panel showing specific color and the auxiliary light-shielding layer can provide the light-shielding region with ideal light-shielding effect to hide the elements not going to be seen in the touch panel. In this way, the appearance of the touch panel gets more diversity to meet the requirement of the users on the product appearance.

## Claims

1. A decoration cover plate (101, 501), having a transparent region (102) and a light-shielding region (104), wherein the light-shielding region (104) is located at at least one side of the transparent region (102), the decoration cover plate (101, 501) comprising:
a substrate (110), made of transparent material;
an appearance decoration layer (130, 630), disposed on the substrate (110) and within the light-shielding region (104) ;
an auxiliary light-shielding layer (140a, 140d), disposed within the light-shielding region (104), wherein the auxiliary light-shielding layer (140a, 140d) and the appearance decoration layer (130, 630) are opposite to each other, and an optical density of the auxiliary light-shielding layer (140a, 140d) is greater than an optical density of the appearance decoration layer (130, 630) ; and
a buffer layer (150a, 150b, 150c), disposed between the appearance decoration layer (130, 630) and the auxiliary light-shielding layer (140a, 140d), wherein a material of the buffer layer (150a, 150b, 150c) is different from a material of the appearance decoration layer (130, 630) and a material of the auxiliary light-shielding layer (140a, 140d).

2. The decoration cover plate (101) as claimed in claim 1, wherein a thickness of the appearance decoration layer (130) ranges between 0.5 micrometers and 50 micrometers.

3. The decoration cover plate (101) as claimed in claim 1, wherein the appearance decoration layer (130) is a mono-layer structure or a multi-layer structure and the optical density of the appearance decoration layer is less than 3.

4. The decoration cover plate (101) as claimed in claim 1, wherein the buffer layer (150a, 150b, 150c) is a mono-layer structure or a multi-layer structure, and the buffer layer (150a, 150b, 150c) is selected from a transparent insulation material, a light-permeable insulation material with a hue or stacked combination layers thereof.

5. The decoration cover plate (101) as claimed in claim 4, wherein the buffer layer (150a) includes a layer made of the transparent insulation material which is further disposed within the transparent region (102).

6. The decoration cover plate (101) as claimed in claim 5, further comprising:
a second buffer layer (190a), disposed between the appearance decoration layer (130) and the substrate (110).

7. The decoration cover plate (101) as claimed in claim 6, wherein the second buffer layer (190a) is a mono-layer structure or a multi-layer structure, the second buffer layer (190a) is selected from a transparent insulation material, a light-permeable insulation material with a hue or stacked combination layers thereof.

8. The decoration cover plate (101) as claimed in claim 7, wherein the second buffer (190a) includes a layer made of the transparent insulation material which is further disposed within the transparent region (102), and a refractive index of the second buffer layer (190a) is different from a refractive index of the buffer layer (150a) and a refractive index of the substrate (110).

9. The decoration cover plate (101) as claimed in claim 7, wherein the second buffer layer (190a) includes a layer made of the transparent insulation material which is further disposed within the transparent region (102), and a refractive index of at least one of the buffer layer (150a) and the substrate (110) is the same as a refractive index of the second buffer layer (190a).

10. The decoration cover plate (101) as claimed in claim 4, wherein the material of the buffer layer (150a) comprises a photosensitive resin or a non-photosensitive resin, a thickness of the buffer layer (150a) ranges between 0.01 micrometers and 10 micrometers, and a refractive index of the buffer layer (150a) ranges 1.2 and 2.

11. The decoration cover plate (101) as claimed in claim 10, wherein the material of the buffer layer (150a) comprises polymer selected from one of siloxane, polyimide, polyurethane, polycarbonate, polyethylene, polystyrene, polyvinylchloride, acrylic and epoxy or a combination thereof.

12. The decoration cover plate (101) as claimed in claim 4, wherein the material of the buffer layer is a transparent inorganic insulation material, a thickness of the buffer layer ranges between 0.001 micrometers and 10 micrometer, and a refractive index of the buffer layer ranges 1.2 and 2.

13. The decoration cover plate (101) as claimed in claim 4, wherein the buffer layer (150a) is the light-permeable insulation material with the hue, and a thickness of the light-permeable insulation material with the hue ranges between 0.5 micrometers and 100 micrometers.

14. The decoration cover plate (101) as claimed in claim 1, wherein material of the auxiliary light-shielding layer (140d) comprises metal or metallic compound, and a thickness of the auxiliary light-shielding layer (140d) ranges between 0.05 micrometers and 0.5 micrometers.

15. The decoration cover plate (101) as claimed in claim 14, further comprising:
an insulation layer (180), at least disposed at a surface of the auxiliary light-shielding layer (140d) far away from the substrate.

16. The decoration cover plate (101) as claimed in claim 1, wherein the material of the auxiliary light-shielding layer (140a) comprises a photosensitive resin or a non-photosensitive resin, and a thickness of the auxiliary light-shielding layer (140a) ranges between 0.3 micrometers and 20 micrometers.

17. The decoration cover plate (101) as claimed in claim 1, wherein the optical density of the auxiliary light-shielding layer (140a) is greater than 3.

18. The decoration cover plate (101) as claimed in claim 1, wherein a material of the substrate (110) is selected from a chemically strengthened glass, a polarizer coated with a hard coat layer, a composite laminate composed of poly (methyl methacrylate) and polycarbonate, or an ultraviolet curable resin material.

19. The decoration cover plate (101) as claimed in claim 1, further comprising:
a conductive layer (120), extending from the transparent region (102) to the light-shielding region (104), wherein in the light-shielding region (104), the conductive layer (120) is disposed at a side of the auxiliary light-shielding layer (140a) far away from the substrate (110).

20. The decoration cover plate (101) as claimed in claim 19, wherein the buffer layer (150a) includes a layer made of a transparent insulation material which is further disposed between the conductive layer (120) and the substrate (110), and the conductive layer (120) contacts a surface of the buffer layer (150a) .

21. The decoration cover plate (101) as claimed in claim 1, further comprising:
a first border shielding layer (631), wherein an outer edge of the appearance decoration layer (630) is separated from an edge of the substrate (110) by a distance, and the first border shielding layer (631) at least covers a portion of an area where the appearance decoration layer (630) is located at and covers the edge of the substrate (110).

22. The decoration cover plate (101) as claimed in claim 21, further comprising:
a second border shielding layer (640), at least covering a portion of an area where the first border shielding layer (631) is located.

23. The decoration cover plate (101) as claimed in claim 1, further comprising:
a second buffer layer (190a), being a continuous overlay not only disposed between the appearance decoration layer (130) and the substrate (110), but also disposed within the transparent region (102).

24. The decoration cover plate (101) as claimed in claim 23, wherein the appearance decoration layer (130) is enclosed by the second buffer layer (190a) and the buffer layer (150a).

25. The decoration cover plate (101) as claimed in claim 1, wherein a portion of the auxiliary light-shielding layer (140a) is patterned to form a light permeable pattern (140b).
